# EUROPÄISCHE PATENTANMELDUNG

(11) **EP 1 282 170 A1**
(43) Veröffentlichungstag der Anmeldung: **05.02.2003**
(21) Anmeldenummer: 01810743.3
(22) Anmeldetag: 30.07.2001
(51) Int. Cl.: H01L 23/58

(54) **Kurzschlussfestes Leistungshalbleiterbauelement**

(71) Anmelder: ABB RESEARCH LTD., 8050 Zürich (CH)
(72) Erfinder: Kaltenborn, Uwe, 5405 Baden-Dättwil (CH); Greuter, Felix, 5406 Rütihof (CH); Hoffmann, Guido, 5404 Baden (CH)
(74) Vertreter: ABB Patent Attorneys

(57) **Zusammenfassung**

Bei einem Leistungshalbleiterbauelement mit einem Halbleiterchip (3) mit zwei Hauptelektroden (5a, 5b) und einem Schmelzelement (2), welches einen Legierungspartner enthält, der mit dem Halbleitermaterial eine Legierung oder ein Eutektikum bilden kann, wird ein stabiler Kurzschluss in einem Defektfall dadurch erreicht, dass ein Abbrandelement (1) vorhanden ist, welches durch eine im Defektfall im Halbleiterchip (3) enstehende Verlustwärme gezündet wird und bei seinem Abbrennen genügend Wärme freisetzt, um den Halbleiterchip (3) und das Schmelzelement (2) aufzuschmelzen und eine Durchlegierung durch die gesamte Dicke des Halbleiterchips (3) zu ermöglichen, wodurch ein dauerhafter metallischer Kontakt zwischen den beiden Hauptelektroden (5a, 5b) herbeigeführt wird.

## Beschreibung

### Technisches Gebiet

Die Erfindung betrifft das Gebiet der Leistungselektronik, insbesondere ein kurzschlussfestes Leistungshalbleiterbauelement nach dem Oberbegriff von Patentanspruch 1.

### Stand der Technik

Leistungselektronische Anlagen bestehen im Allgemeinen aus einem oder mehreren Umrichtern oder Stromrichtern und einer oder mehreren Steuereinheiten, welche die Umrichter oder Stromrichter kontrollieren. Ein Umrichter oder Stromrichter besteht selbst aus einer oder mehreren untereinander verbundenen Schalteinheiten. Jede Schalteinheit muss in der Lage sein, einen für sie vorgegebenen Gesamtnennstrom zu schalten und einer vorgegebenen Gesamtnennspannung standzuhalten. Jede Schalteinheit weist wiederum ein oder mehrere Leistungshalbleiterbauelemente mit je zwei Hauptanschlüssen auf, die alle selbst als Schalter fungieren und einen vorgegebenen Teilnennstrom schalten bzw. einer vorgegebenen Teilnennspannung standhalten können. Im Falle von mehreren Halbleiterbauelementen können diese parallel, in Serie, in Serie von parallelen Gruppen oder als parallele Serien geschaltet sein. Im Falle von in Serie geschalteten, identischen Bauelementen wird eine an die Serienschaltung angelegte Spannung im Idealfall gleichmässig auf alle Bauelemente verteilt, im Falle parallelgeschalteter Bauelemente ein die Parallelschaltung durchfliessender Strom. Um eine grösstmögliche Verfügbarkeit der Anlage zu gewährleisten, sind die Schalteinheiten im Allgemeinen redundant aufgebaut. Das bedeutet, dass bei einem Defekt eines oder mehrerer Halbleiterbauelemente sich bei Anliegen der Gesamtnennspannung an bzw. Fliessen des Gesamtnennstromes durch die Schalteinheit die Spannung bzw. der Strom so auf die noch intakten Bauelemente verteilt, dass für kein Bauelement die Teilnennspannung bzw. der Teilnennstrom überschritten wird. Damit die Schalteinheit auch in einem solchen Fall voll funktionsfähig bleibt, ist es in vielen Fällen erforderlich, dass defekte Bauelemente in einen stabilen Kurzschlussmodus ("short-circuit failure mode", SCFM) übergehen, in welchem zwischen den beiden Hauptanschlüssen ein dauerhafter elektrischer Kontakt mit möglichst geringem Widerstand und möglichst grosser Stromkapazität besteht. Solche Bauelemente bezeichnet man als kurzschlussfest. Ein Defekt eines Bauelements kann dabei aus verschiedenen Gründen zustande kommen. Eine mögliche Ursache ist ein Überstrom, d.h. dem Bauelement wird aufgrund externer Ursachen ein Strom aufgezwungen, der seinen Teilnennstrom übersteigt. Dies führt im Allgemeinen zu einem internen Defekt, der jedoch auch aus anderen Gründen zustande kommen kann, z.B. durch alterungsbedingte Veränderung der internen Struktur des Bauelements. Interne Defekte können aber auch durch Überhitzung aufgrund einer Verlustleistung an einem Kontaktwiderstand, der sich durch Korrosion oder Ermüdungserscheinungen von Lötstellen durch thermo-mechanische Effekte bzw. Elektromigration ausbilden kann, entstehen. Die vorgenannten Effekte können jedoch auch ohne Ausbildung eines internen Defekts zu Ausfällen des Bauelements führen. Sämtliche derartigen Fehler, Ausfälle oder Defekte werden im Folgenden als Defekt bezeichnet.

Besteht also zum Beispiel eine Schalteinheit aus einem Stapel mehrerer in Serie geschalteter Bauelemente, der redundante Bauelemente enthält, können bei einem Defekt eines kurzschlussfesten Bauelements die restlichen Elemente im Stapel in einer Sperrphase eine an die Schalteinheit angelegte Spannung aufnehmen, solange diese kleiner ist als die Gesamtnennspannung. Andererseits kann in einer Durchlassphase ein Strom ungehindert durch das ausgefallene Bauteil hindurch gehen. Bei einem Defekt eines nicht kurzschlussfesten Bauelements hingegen würde dieses den Stromfluss unterbrechen. Dies würde dazu führen, dass die gesamte an die Schalteinheit angelegte Spannung an diesem einen Bauelement anliegen würde, was zu Durchbrüchen mit sehr hoher Leistungsdichte und/oder zur Ausbildung von Lichtbögen führen würde. Als Folge davon würde die gesamte Schalteinheit zerstört. Im ungünstigsten Fall könnte dies zu massiven Schäden an der gesamten Anlage führen, in welcher der Strom- bzw. Umrichter eingebaut ist.

Bei einigen Bauelementen mit grossen Chipflächen, z.B. bei druckkontaktierten Thyristoren, führt ein Defekt häufig von alleine zu einem Kurzschluss, der über lange Zeit stabil erhalten bleibt. Hier befindet sich beispielsweise ein Halbleiterchip aus Silizium in mechanischem und elektrischem Kontakt zwischen zwei Molybdän-Scheiben. Silizium hat einen Schmelzpunkt von 1420°C, derjenige von Molybdän liegt höher und Legierungen aus Silizium und Molybdän haben einen nochmals höheren Schmelzpunkt. Im Defektfall schmilzt daher als erstes das Silizium des Halbleiterchips lokal auf und es bildet sich unter Stromfluss ein leitender Kanal aus geschmolzenem Silizium, der von einer Molybdänscheibe zur anderen reicht. Diese Defektzone kann sich ausbreiten und/oder verschieben, wird aber stets nur einen kleinen Teil der Chipfläche betreffen. In hermetisch abgeschlossenen Gehäusen oxidiert das geschmolzene Silizium nicht, sondern reagiert mit Molybdän zu einer pulverartigen Substanz, so dass ein dauerhafter, elektrischer Kontakt entsteht, der über einen langen Zeitraum erhalten bleibt.

In üblichen IGBT (Insulated Gate Bipolar Transistor) Modulen sind hingegen normalerweise mehrere kleinflächige Einzelchips getrennt nebeneinander angeordnet. Ein derartiges Modul ist z.B. aus EP 499 707 B1 bekannt. Es hat sich gezeigt, dass für solche druckkontaktierte IGBT Module wegen der reduzierten Fläche der Einzelchips bzw. eines geringen Siliziumvolumens keine stabilen Kurzschlüsse erwartet werden können, d.h. dass ein Kurzschluss, der sich nach einem Defekt mit resultierendem Aufschmelzen eines Einzelchips ausbildet, nach wenigen Stunden von selbst wieder unterbrochen wird. In DE 198 43 309 AI wurde daraufhin eine Lösung für ein kurzschlussfestes IGBT-Modul vorgestellt. Dabei wird ein Schmelzelement, das einen Legierungspartner enthält, als Folie, Paste oder Lotbestandteil auf die Einzelchips des IGBT aufgebracht. Im Falle eines Defekts eines Chips soll eine Verlustwärme, die der Strom durch den IGBT erzeugt, zu einem Diffussionsprozess führen, in dessen Verlauf der Legierungspartner mit dem Silizium des Chips eine Legierung, vorzugsweise ein Eutektikum, eingeht. Eine resultierende Legierungszone ist deutlich leitfähiger als das Halbleitermaterial des Chips und kann somit nach einem Auftreten eines Defekts des Chips den Strom tragen. Dadurch kann ein Kurzschluss mit einem internen oder externen Lichtbogen vermieden werden, und das Gesamtsystem ist weiterhin einsatzfähig. Diese Vorgehensweise bringt jedoch einige Probleme mit sich, da eine wie beschrieben ablaufende Durchlegierung durch verschiedene Faktoren behindert wird. So existieren Kombinationen aus Halbleitermaterial und Legierungspartner, die sogenannte Zwischenphasen bilden, d.h. Mischungen mit einem Mengenverhältnis innerhalb einer gewissen Bandbreite oder auch einem streng stöchiometrischen Mengenverhältnis, die durch bestimmte physikalische Eigenschaften charakterisiert sind. Solche Zwischenphasen sind relativ stabil und behindern den Diffusionsprozess, so dass eine Durchlegierung des Chips nicht mehr garantiert ist. Speziell im Fall von Silizium als Halbleitermaterial bilden sich bei vielen Legierungspartnern Legierungsfronten, also Bereiche, in denen eine Zwischenphase vorherrscht. Ein Verlauf dieser Legierungsfronten ist sehr stark von der Morphologie des Siliziums und insbesondere von einer Grenzflächenbeschaffenheit abhängig. Der Diffusionprozess wird ausserdem an Korngrenzen oder kristallin-amorphen Phasenübergängen behindert. Es kommt zu einem Konzentrationsgefälle mit lokal erhöhten Siliziumanteilen. Mit erhöhtem Siliziumanteil wird jedoch auch eine erhöhte Temperatur benötigt, um ein Stoffgemenge aus Silizium und Legierungspartner aufzuschmelzen und eine Legierung durch den Chip zu garantieren. Die notwendigen Temperaturen werden somit durch die Verlustwäme des IGBT nicht mehr erreicht. Insgesamt wird die Methode dadurch in ihrer Zuverlässigkeit begrenzt, wie sich bei realen Versuchen gezeigt hat. Um die genannten Probleme zu umgehen, versuchte man bisher, solche Legierungspartner zu verwenden, die mit dem Halbleitermaterial keine Zwischenphasen ausbilden. Dies bringt jedoch Nachteile mit sich, da solche Materialien nicht immer existieren oder gegebenenfalls andere unerwünschte Eigenschaften besitzen.

Die begrenzte Verlustwärme im Defektfall bringt darüber hinaus das Problem mit sich, dass nur solche Materialien als Legierungspartner eingesetzt werden können, bei denen der Legierungsschmelzpunkt oder die eutektische Temperatur der Legierung des Legierungspartners mit dem Halbleitermaterial deutlich unter einer durch die in einem defekten Chip anfallende Verlustwärme erreichten Temperatur des Schmelzelements liegt. Aus diesem Grund muss bei Siliziumbauelementen in vielen Fällen auf Aluminium als Legierungspartner zurückgegriffen werden, weil bei diesem der eutektische Punkt mit etwa 580°C relativ niedrig liegt. Aufgrund einer Oxidationsanfälligkeit von Aluminium ist der Einsatz dieses Materials ausserhalb hermetisch abgeschlossener Gehäuse jedoch problematisch.

### Darstellung der Erfindung

Der vorliegenden Erfindung liegt die Aufgabe zugrunde, ein kurzschlussfestes Leistungshalbleiterbauelement mit einem Halbleiterchip und einem Schmelzelement zu schaffen, bei dem im Fall eines Defekts ein hinreichend starkes Aufschmelzen und eine genügende Durchmischung zwischen dem Material des Halbleiterchips und einem Legierungspartner im Schmelzelement gewährleistet sind, so dass das Bauelement zuverlässig in einen stabilen Kurzschlussmodus mit minimalem Widerstand übergeht. Eine weitere Aufgabe ist, die bestehende Beschränkung auf Legierungspartner, die mit dem Halbleitermaterial keine Zwischenphasen bilden und/oder deren Legierungsschmelzpunkt oder eutektischer Punkt mit dem Halbeitermaterial möglichst niedrig liegt, zu eliminieren.

Diese Aufgabe wird durch ein kurzschlussfestes Leistungshalbleiterbauelement nach Anspruch 1 gelöst. Erfindungsgemäss weist das Leistungshalbleiterbauelement ein Abbrandelement auf, welches ein Hochenergiematerial (HEM) enthält. Unter einem HEM wird eine Substanz verstanden, die durch Zündung, d.h. durch Zuführung einer Aktivierungsenergie, zum Ablauf einer exothermen chemischen Reaktion bringbar ist. Ein spezifischer Brennwert eines HEM beträgt dabei bei vorzugsweise mindestens 200 J/g, besser jedoch mehr als 300 J/g. Im Defektfall wird das Abbrandelement gezündet, worauf eine beim Abbrennen freiwerdende Energie dem Halbleiterchip und dem Schmelzelement zugeführt wird. Dadurch wird die oben beschriebene Behinderung einer Durchlegierung aufgehoben und die Zuverlässigkeit der Kurzschlussausbildung erhöht. Ausserdem entfallen die Beschränkungen für die Wahl des Legierungspartners.

In einer bevorzugten Ausgestaltung der Erfindung ist das HEM so gewählt, dass die Aktivierungsenergie thermisch zuführbar ist, d.h. durch Erwärmung des HEM auf eine Zündtemperatur. Eine Vielzahl derartiger HEM sind in der Technik bekannt und kostengünstig verfügbar. Ausserdem kann sowohl die Zündtemperatur als auch die Menge der beim Abbrennen freiwerdenden Energie und eine sich einstellende Abbrandtemperatur geeignet gewählt werden.

In einer weiteren vorteilhaften Ausgestaltung der Erfindung ist das Abbrandelement derart angebracht, dass es durch eine im Defektfall anfallende Verlustwärme erwärmbar ist. Dabei wird eine Zündtemperatur des HEM so gewählt, dass sie höher ist als eine maximale Betriebstemperatur, aber niedriger als eine im Defekt-fall sich einstellende Defekttemperatur. Bei dieser Ausgestaltung erübrigen sich zusätzliche Mittel zur Zündung des Abbrandelements.

Weitere vorteilhafte Ausführungsformen gehen aus den Ansprüchen hervor.

### Kurze Beschreibung der Figuren

Nachfolgend wird die Erfindung anhand von Ausführungsbeispielen im Zusammenhang mit den Zeichnungen näher erläutert. Es zeigen schematisch:
Abb.1 einen Schnitt durch ein erfindungsgemässes Leistungshalbleiterbauelement vor Aktivierung eines Abbrandelements.
Abb.2 einen Schnitt durch ein erfindungsgemässes Leistungshalbleiterbauelement nach Aktivierung des Abbrandelements und einer Ausbildung einer Legierungszone.
Abb.3 einen Schnitt durch ein erfindungsgemässes Leistungshalbleiterbauelement vor der Aktivierung des Abbrandelements in einer zweiten Ausführungsform.
Abb.4 einen Schnitt durch ein erfindungsgemässes Leistungshalbleiterbauelement vor der Aktivierung des Abbrandelements in einer dritten Ausführungsform.
Die in den Zeichnungen verwendeten Bezugszeichen und deren Bedeutung sind in der Bezugszeichenliste zusammengefasst.

### Wege zur Ausführung der Erfindung

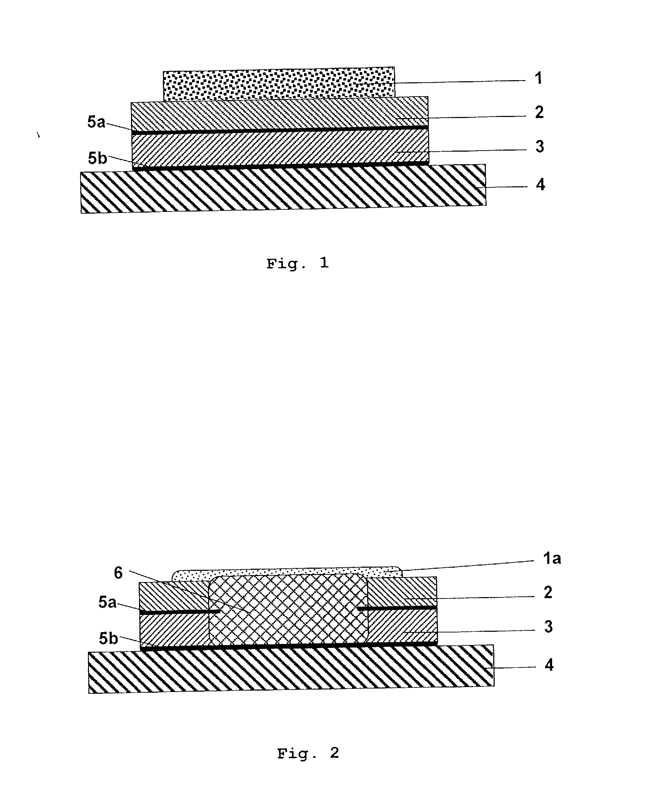

In Abb. 1 ist ein Querschnitt einer ersten Ausführungsform eines erfindungsgemässen, kurzschlussfesten Leistungshalbleiterbauelements gezeigt. Ein Halbleiterchip 3 weist dabei zwei Hauptelektroden 5a, 5b auf und ist mittels einer ersten Hauptelektrode 5a mit einem leitenden Substrat 4 kontaktiert. Art und interne Struktur des Halbleiterchips 3 sind dabei von untergeordneter Bedeutung. Vorzugsweise zielt die Erfindung auf kleinflächige Halbleiterchips, die intern beispielsweise eine IGBToder Diodenstruktur aufweisen. Prinzipiell ist die Erfindung jedoch auch in Verbindung mit anders gearteten Halbleiterchips 3 ausführbar, die über zwei Hauptelektroden 5a und 5b verfügen, zwischen denen sich im Defektfall ein Kurzschluss ausbilden soll.

Ein Schmelzelement 2 ist wiederum als im wesentlichen planare Schicht auf einer zweiten Hauptelektrode 5b des Halbleiterchips 3 aufgebracht. Dabei muss das Schmelzelement 2 die Hauptelektrode 5b nicht notwendigerweise vollständig bedecken, jedoch sollte es vorzugsweise einen wesentlichen Teil im Bereich von annähernd 50% bis 100% der Hauptelektrode 5b bedecken. Das Schmelzelement 2 enthält mindestens einen Legierungspartner, der mit dem Material des Halbleiterchips eine Legierung, vorzugsweise ein Eutektikum, bilden kann. Im Falle von Si als Halbleitermaterial kommen hierfür Metalle wie Al, Ag, Cu, Mo etc. als Materialkomponenten des Schmelzelements 2 in Frage. Vorzugsweise können dabei Legierungspartner verwendet werden, die mit dem Halbleitermaterial Zwischenphasen ausbilden können, im Falle von Si z.B. Cu. Erfindungsgemäss ist ein Abbrandelement 1 in einer möglichen Ausführungsvariante so auf der Oberseite des Schmelzelements angebracht, dass es vorzugsweise annähernd 50% bis 100% der Oberseite des Schmelzelements bedeckt. Das Abbrandelement 1 weist als erstes Hochenergiematerial vorzugsweise einen Brennstoff und einen Oxidator auf, welche bei Erreichen der Zündtemperatur unter einer Wärmefreisetzung miteinander zu Asche 1a reagieren.

Brennstoffe sind vorzugsweise nitro-organische Substanzen, zum Beispiel Guanidine und Guanidinderivate wie Diguanidinium-5,5'azotetrazolat (GZT), Guadinnitrat und Guanidinazetat, von denen auch Mischungen eingesetzt werden können. Als Oxidator eignen sich sauerstoffreiche Verbindungen, vor allem Nitrate, Chlorate, Perchlorate und Permanganate wie KNO₃, NaNO₃, NH₄NO₃, KClO₄, NaClO₄, KMnO₄. Der Oxidator ist im Abbrandmaterial vorzugsweise in einem überstöchiometrischen Verhältnis zum Brennstoff vorhanden. Dabei ist das stöchiometrische Verhältnis von Oxidator zu Brennstoff vorzugsweise mindestens 1.1:1, besser jedoch zwischen 10:1 und 15:1. Dies führt zu einer vollständigen Oxidation des Brennstoffs in einer sehr rasch ablaufenden Reaktion.

In einer weiteren bevorzugten Ausführung der Erfindung weist der Brennstoff zur Erhöhung der Wärmefreisetzung ausserdem ein zweites Hochenergiematerial mit einer zweiten Zündtemperatur in Form eines Zusatzstoffs auf, der mindestens ein Metall wie Mg, Al, Zr, Hf, Th enthält. In diesem Fall ist es günstig, wenn der Oxidator zusätzlich ein Metalloxid aufweist, das mit mindestens einem der im Zusatzstoff enthaltenen Metalle eine thermitische Reaktion eingeht, zum Beispiel Fe₂O₃.

Durch Auswahl und Dosierung des Oxidators derart, dass er bei einer bestimmten Temperatur eine ausreichende Menge Sauerstoff freisetzt, kann die Zündtemperatur des ersten Hochenergiematerials und somit die Zündtemperatur des Abbrandelements mit verhältnismässig grosser Genauigkeit - i. a. auf ±10°C - im Bereich zwischen annähernd 180°C und 450°C eingestellt werden. Dabei müssen die Materialien so gewählt werden, dass die Zündtemperatur höher ist als eine maximale Betriebstemperatur, aber niedriger als eine Defekttemperatur. Unter der maximalen Betriebstemperatur ist in diesem Zusammenhang eine Temperatur zu verstehen, die um eine Toleranztemperatur, welche vorzugsweise im Bereich zwischen 20K und 100K liegt, höher ist als die höchste Temperatur, welche sich bei einem Betrieb des Bauelements in intaktem Zustand in der vorgesehenen Art unter vorgesehenen Betriebsbedingungen im Abbrandelement einstellt. Unter der Defekttemperatur ist ein Höchstwert eines Temperaturverlaufes zu verstehen, welcher sich als Folge einer freigesetzten Verlustwärme im Abbrandelement bei einem Defekt des Bauelements einstellt.

Allfällig im Brennstoff zur Erhöhung der Wärmefreisetzung enthaltene Zusatzstoffe werden durch die Reaktion des organischen Anteils des Brennstoffs mit dem Oxidator auf die zweite Zündtemperatur erhitzt und nehmen ebenfalls an der Reaktion teil, wodurch sie einen wesentlichen Beitrag zur Wärmefreisetzung leisten. So können Temperaturen von 1'700°C und mehr erreicht werden.

Folgende Abbrandmaterialien kommen beispielsweise in Frage (die Anteile werden in % Masse angegeben):
1: 3.5% Guanidinnitrat, 30% GZT, 66.5% KMnO₄
2: 27.5% Guanidinnitrat, 16.7% Guanidinazebat, 9.2% Mg, 46.7% KMnO₄
3: 7.1% Guanidinazetat, 92.9% KMnO₄
4: 26.8% GZT, 13.4% Guanidinazetat, 59.8% KMnO₄
5: 33.3% Guanidinnitrat, 11.1% Mg, 55.6% KMnO₄
6: 60% GZT, 40% KMnO₄
7: 40% GZT, 6% Mg, 54% KMnO₄

Dabei wurden für die Zündtemperatur und die Wärmefreisetzung folgende Werte ermittelt:

| Abbrandmaterial | Zündtemperatur [°C] | Wärmefreisetzung [J/g] |
|---|---|---|
| 1 | 177 | 861 |
| 2 | 205 | 862 |
| 3 | 208 | 402 |
| 4 | 233 | 760 |
| 5 | 236 | 714 |
| 6 | 255 | 330 |
| 7 | 258 | 580 |

Höhere Zündtemperaturen lassen sich auf einfache Weise beispielsweise durch Zugabe von Fe₂O₃ realisieren.

In einer bevorzugten Ausgestaltung der Erfindung weist das Abbrandelement 1 metallisch leitfähige HEM auf. Diese basieren auf einem Gemisch aus Zirkonium und metastabilen Zirkoniumoxid, das ebenfalls mit einem geeigneten Oxidator versehen wird. Auch hier lassen sich durch eine entsprechende Auswahl von Brennstoffanteil und Oxidatorgemisch die Zündtemperaturen sehr genau im Bereich zwischen 180°C und 450 °C einstellen.

Im Defektfall wird das Abbrandelement 1 durch die Verlustwärme gezündet. Durch die freigesetzte Energie schmilzt zunächst das Schmelzelement 2, im weiteren Verlauf auch der Halbleiterchip 3 in einem Bereich unter dem Abbrandelement 1 auf. Dadurch kommt es zur Ausbildung einer homogenen Legierungsschicht 6, die durch den gesamten Halbleiterchip 3 hindurch führt und einen metallisch leitenden Kontakt zwischen den beiden Hauptelektroden 5a und 5b herstellt, wie in Abb. 2 schematisch gezeigt ist.

Hochenergiematerialien können in der Regel in geeigneten Lösungsmitteln gelöst werden. Damit ergeben sich verschiedenste Applikationsmöglichkeiten. Die Materialien können aufgestrichen, aber auch per Siebdruck aufgedruckt werden. Prinzipell sind auch pressbare Formmassen möglich.

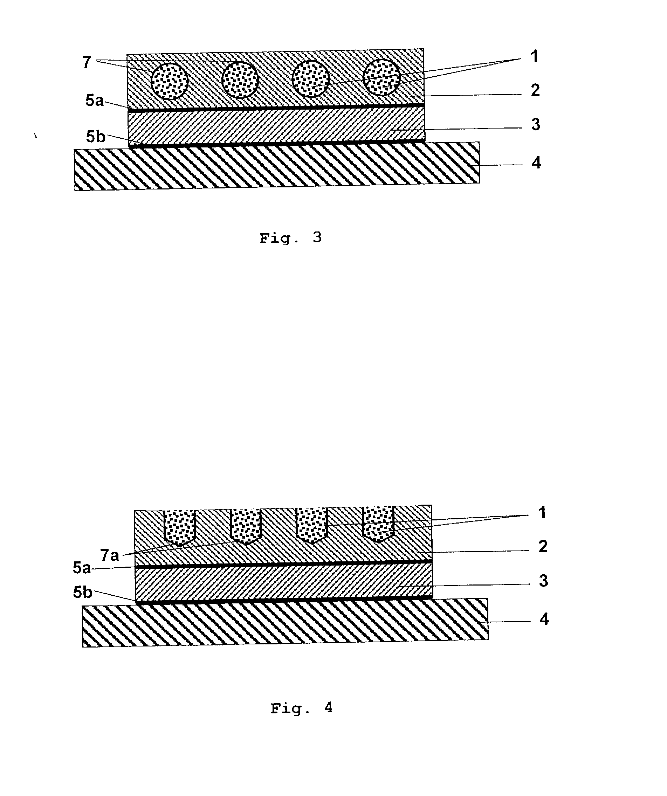

In einer weiteren bevorzugten Ausgestaltung der Erfindung weist das Schmelzelement 2 Hohlräume, z.B. Bohrungen, Aussparungen oder Löcher, auf, die jeweils ein oder mehrere Abbrandelemente enthalten. Abb. 3 zeigt schematisch einen Querschnitt einer Ausführungsform, bei welcher Bohrungen 7 parallel zu den Hauptelektroden 5a und 5b verlaufen. Abb. 4 zeigt einen Querschnitt einer weiteren Ausführungsform, bei der Bohrungen 7a senkrecht zur Schmelzelement-Schicht verlaufen. Vorteilhaft bei beiden Ausführungsformen ist die Möglichkeit, im Falle eines gut leitfähigen Schmelzelements 2, insbesondere bei metallischen Schmelzelementen, eine elektrische Kontaktierung über die Schmelzelementschicht vorzunehmen, z.B durch Kontaktstempel oder Bonddrähte, die auf der vom Halbleiterchip 3 abgewandten Seite des Schmelzelements 2 aufliegen, aufgepresst oder aufgelötet sind.

In einer weiteren bevorzugten Ausführungsform, insbesondere in Kombination mit Hohlräumen zum Auffüllen mit dem Abbrandelement, ist das Schmelzelement 2 zwischen dem Substrat 4 und dem Halbleiterchip 3 angeordnet.

### Bezugszeichenliste

- 1: Abbrandelement
- 1a: Asche des Abbrandelements nach dem Abbrennen
- 2: Schmelzelement
- 3: Halbleiterchip
- 4: Substrat
- 5a: Erste Hauptelektrode
- 5b: Zweite Hauptelektrode
- 6: Eutektikum oder Legierung aus Halbleitermaterial und Legierungspartner des Schmelzelements
- 7: Parallel zu den Hauptelektroden verlaufende erste Hohlräume
- 7a: Senkrecht zu den Hauptelektroden verlaufende zweite Hohlräume

## Patentansprüche

1. Kurzschlussfestes Leistungshalbleiterbauelement mit
- einem Halbleiterchip (3) aus einem ersten Material und
- mindestens einem Schmelzelement (2), welches ein zweites Material als Legierungspartner enthält, wobei zwischen dem zweiten Material und dem ersten Material eine Legierung, vorzugsweise ein Eutektikum, bildbar ist,
**dadurch gekennzeichnet, dass**
- das Leistungshalbleiterbauelement mindestens ein Abbrandelement (1) aufweist, welches mindestens ein erstes Hochenergiematerial enthält, das durch Zuführung einer Aktivierungsenergie zum Ablauf einer exothermen chemischen Reaktion bringbar ist.

2. Leistungshalbleiterbauelement nach Anspruch 1, **dadurch gekennzeichnet, dass**
- die Aktivierungsenergie durch Erwärmung des ersten Hochenergiematerials auf eine erste Zündtemperatur zuführbar ist.

3. Leistungshalbleiterbauelement nach Anspruch 2 mit
- einer maximalen Betriebstemperatur bei Betrieb des Leistungshalbleiterbauelements in einem intakten Zustand
- einer in einem Defektfall im Halbleiterchip (3) anfallenden Verlustwärme,
- einer im Defektfall aufgrund der Verlustwärme sich einstellenden Defekttemperatur,
**dadurch gekennzeichnet, dass**
- das Abbrandelement (1) im Defektfall durch die Verlustwärme erwärmbar ist und
- die erste Zündtemperatur des Abbrandelements (1) höher ist als die maximale Betriebstemperatur und niedriger als die Defekttemperatur.

4. Leistungshalbleiterbauelement nach Anspruch 3, **dadurch gekennzeichnet, dass**
- eine Legierung des ersten Materials mit dem zweiten Material in einem beliebigen Mischungsverhältnis bei Temperaturen niedriger als die Defekttemperatur einen festen Aggregatszustand bildet.

5. Leistungshalbleiterbauelement nach Anspruch 3 oder 4,
**dadurch gekennzeichnet, dass**
- das Abbrandelemente mindestens zwei verschiedene Hochenergiematerialien enthält, und dass
- eine zweite Zündtemperatur eines zweiten Hochenergiematerials höher ist als die Defekttemperatur, aber niedriger als eine Abbrandtemperatur, welche bei der exothermen Reaktion eines ersten Hochenergiematerials entsteht.

6. Leistungshalbleiterbauelement nach einem der Ansprüche 1 bis 5, **dadurch gekennzeichnet, dass**
- der Halbleiterchip (3) zwei Hauptelektroden 5a und 5b aufweist und dass
- das Schmelzelement (2) als im wesentlichen planare Schicht auf einer der beiden Hauptelektroden 5a oder 5b ausgeführt ist.

7. Leistungshalbleiterbauelement nach einem der vorangehenden Ansprüche, **dadurch gekennzeichnet, dass**
- das Abbrandelement (1) als Schicht auf dem Schmelzelement (2) ausgeführt ist.

8. Leistungshalbleiterbauelement nach Anspruch 6, **dadurch gekennzeichnet, dass**
- das Schmelzelement (2) ein oder mehrere Hohlräume aufweist und mindestens einer der Hohlräume ein Abbrandelement (1) enthält.

9. Leistungshalbleiterbauelement nach einem der Ansprüche 1 bis 8, **dadurch gekennzeichnet, dass**
- zwischen dem ersten Material und dem zweiten Material Zwischenphasen ausbildbar sind.

10. Leistungshalbleiterbauelement nach einem der Ansprüche 1 bis 9, **dadurch gekennzeichnet, dass**
- das Leistungshalbleiterbauelement ein IGBT oder eine Diode ist.

11. Verfahren zur Herstellung eines kurzschlussfesten Leistungshalbleiterbauelements mit
- einem Halbleiterchip (3) aus einem ersten Material und
- mindestens einem Schmelzelement (2), welches ein zweites Material als Legierungspartner enthält, wobei zwischen dem zweiten Material und dem ersten Material eine Legierung bildbar ist,
**dadurch gekennzeichnet, dass**
- das Leistungshalbleiterbauelement mindestens ein Abbrandelement (1) aufweist, welches mindestens ein erstes Hochenergiematerial enthält, das zum Ablauf einer exothermen chemischen Reaktion bringbar ist und dass
- das Hochenergiematerial in einem Lösungsmittel gelöst wird und aufgestrichen oder per Siebdruck aufgedruckt wird.
